# EUROPÄISCHE PATENTSCHRIFT

(11) **EP 1 986 050 B1**
(45) Veröffentlichungstag und Bekanntmachung des Hinweises auf die Patenterteilung: **23.05.2012**
(21) Anmeldenummer: 08006775.4
(22) Anmeldetag: 03.04.2008
(51) Int. Cl.: G03F 7/00

(54) **Vorrichtung zum Bedrucken und/oder Prägen von Substraten**
Device for printing and/or embossing substrates
Dispositif d'impression et/ou imprégnation de substrats

(30) Priorität: 24.04.2007 DE 102007019268
(43) Veröffentlichungstag der Anmeldung: 29.10.2008
(73) Patentinhaber: Thallner, Erich, 4782 St. Florian (AT)
(72) Erfinder: Thallner, Erich, 4782 St. Florian (AT)
(74) Vertreter: Schweiger, Johannes

(56) Entgegenhaltungen:
- US-A1- 2006 043 626
- US-A1- 2006 286 193
- US-A1- 2008 041 248
- US-B1- 6 353 219

## Beschreibung

Die Erfindung betrifft eine Vorrichtung zum Bedrucken und/oder Prägen von Substraten (7), insbesondere Halbleitersubstraten oder Wafern, mit:
- einer Aufnahmeeinheit (5) zur Aufnahme des Substrats (7) in einem Arbeitsraum (13),
- einer Justiereinrichtung (2, 3, 4) zur Justierung des Substrats (7) gegenüber einem Präge- und/oder Druckstempel (10).

Bei den genannten Verfahren mit Stempelübertragung auf ein Substrat, wie beispielsweise micro-contact-printing (µCP) sowie Prägeverfahren und/oder Druckverfahren zur Herstellung von Halbleitersubstraten ist es vielfach erforderlich, den Stempelvorgang in einer definierten Atmosphäre, wie beispielsweise einer Schutzgasatmosphäre oder im Vakuum bzw. Teilvakuum ablaufen zu lassen. Da eine Justierung/Positionierung der Halbleitersubstrate zu dem Stempel erforderlich ist, sind bisher Justiereinrichtungen innerhalb einer mit der definierten Atmosphäre beaufschlagbaren Kammer angeordnet.

Auf Grund der teilweise sehr großen Durchmesser der Halbleitersubstrate, die beispielsweise im step-and-repeat-Verfahren gestempelt werden, weisen diese Justiereinrichtungen teilweise erhebliche Abmessungen auf, da eine exakte Justierung/Positionierung in allen drei Richtungen mit teilweise erheblicher Auslenkung der Halbleitersubstrate erforderlich ist. Je größer das Kammervolumen ist, desto stabiler und mit erheblichen Wandstärken muss die Vorrichtung aufgebaut sein, um den teils beträchtlichen Druckdifferenzen standzuhalten.

Weiterhin besteht das Problem, dass die für die Justiereinrichtung erforderlichen Steuerleitungen aus der Kammer herausgeführt werden müssen, wobei eine Abdichtung gegenüber der Kammer zu gewährleisten ist. Es besteht außerdem das Problem, dass die Justiereinrichtung in verschiedenen Atmosphären bzw. unter verschiedenen Drücken hochpräzise arbeiten muss.

Vorrichtungen zum Bedrucken/Prägen von Substraten sind in der US 2006/0043626 A1 und der US 2006/0286193 A1 offenbart.

Der Erfindung liegt daher die Aufgabe zugrunde, eine möglichst kontaminationsfrei arbeitende Vorrichtung vorzuschlagen, die kostengünstig zu fertigen ist.

Diese Aufgabe wird mit den Merkmalen des Anspruchs 1 gelöst. Vorteilhafte Weiterbildungen der Erfindung sind in den Unteransprüchen angegeben.

Grundidee der vorliegenden Erfindung ist es, die Verschiebung/Positionierung/Justierung des Substrats gegenüber dem Stempel von außerhalb der einen Arbeitsraum begrenzenden Kammer zu bewirken. Dies bringt den Vorteil mit sich, dass die Justiereinrichtung außerhalb der Kammer und damit unabhängig von der Atmosphäre innerhalb der Kammer betrieben werden kann. Die Abmessungen der Kammer können daher wesentlich kleiner ausfallen.

Diese Grundidee kann verwirklicht werden, indem beispielsweise ein unterer Teil der Kammer als Aufnahmeeinrichtung für das Substrat gegen einen oberen Teil der Kammer, der die Stempeleinheit umfasst, abstützend ausgebildet ist und die beiden Kammerteile gegeneinander mittels der Justiereinrichtung in einer Ebene verschiebbar sind.

Der den Stempel aufnehmende Kammerteil ist vorzugsweise in X- und Y-Richtung nicht verschieblich, während der Stempel gegenüber diesem Teil der Kammer in Z-Richtung verschieblich ist. Je nach Anwendungsfall kann der Stempel auch rotieren oder in X- und/oder Y-Richtung verschieblich gelagert sein. Der das Substrat aufnehmende Kammerteil ist dagegen in X- und Y-Richtung verschieblich, nicht aber in Z-Richtung, allenfalls durch geringfügige Verschiebung der beiden Kammerteile zueinander, beispielsweise durch Abschalten oder Aktivieren eines weiter unten beschriebenen Fluidlagers.

Mit X- und Y-Richtung sind zwei orthogonal zueinander ausgerichtete, eine Ebene parallel zu der Substratoberfläche aufspannende, Richtungen gemeint. Die Z-Richtung liegt orthogonal zu dieser Ebene.

In ihrer allgemeinsten Ausführungsform ist die Aufnahmeeinheit den Arbeitsraum von der Umgebung abtrennend ausgebildet. Mit abtrennend ist dabei gemeint, dass im Arbeitsraum befindliches Fluid nicht unbeabsichtigt entweichen kann. Unter Fluid im Sinne der vorliegenden Erfindung wird jedes fließfähige, also beispielsweise gasförmige und/oder flüssige Medium einschließlich eines Vakuums subsumiert.

Stempel und Substrat sind demnach in einem abgetrennten Arbeitsraum mit Vakuum und/oder einer definierten Atmosphäre beaufschlagbar.

Indem der abgetrennte Arbeitsraum durch einen den Stempel aufnehmenden Aufbau, eine Justierplatte und eine das Substrat aufnehmende Aufnahmeeinheit gebildet ist, wird der Arbeitsraum mit möglichst wenigen Bauteilen und dadurch kleinstmöglich gebildet und eine stabile Konstruktion kann gewährleistet werden.

Unter Arbeitsraum im Sinne der Erfindung wird der Raum verstanden, in welchem der wesentliche Prozess, nämlich das Prägen oder Bedrucken des Substrates durch den Stempel erfolgt.

Mit Vorteil ist die Justiereinrichtung zumindest teilweise, vorzugsweise vollständig, außerhalb des Arbeitsraums angeordnet. Im Rahmen der Erfindung ist auch eine Ausführungsform, bei der beispielsweise nur eine Bewegungsrichtung und damit beispielsweise nur eine in X- oder Y-Richtung arbeitende Justiereinrichtung außerhalb des Arbeitsraums angeordnet ist und die das Substrat aufnehmende Aufnahmeeinheit gegenüber dem den Stempel aufnehmenden Aufbau geführt ist, beispielsweise durch eine Verzahnung bzw. Nut-Feder-Verbindung, so dass eine Verschiebung der Aufnahmeeinheit gegenüber dem Aufbau nur in einer Richtung möglich ist.

Besonders vorteilhaft ist es, zwischen der, insbesondere wannenförmigen, Aufnahmeeinheit und der Justierplatte ein durch mindestens eine Fluidzuleitung mit Fluid, insbesondere Luft, vorzugsweise Reinluft, gespeistes Fluidlager vorzusehen. Durch ein solches Fluidlager ist eine nahezu reibungsfreie Verschiebung der Aufnahmeeinheit zu der Justierplatte des Aufbaus möglich, wodurch eine höchst präzise Justierung mit geringst möglichem Kraftaufwand verwirklicht ist.

Gegenüber einer kontaktgeführten Verbindung zwischen der Aufnahmeeinheit und der Justierplatte besteht weiterhin der Vorteil, dass Abriebpartikel und damit Kontaminationen im Arbeitsraum vermieden werden. Jede Verschmutzung der Atmosphäre im Arbeitsraum beeinträchtigt den Präge- bzw. Druckprozess.

Indem die Aufnahmeeinheit, insbesondere einstückig, aus einem Aufnahmeboden und einer Umfangsschulter gebildet ist, wobei die Umfangsschulter eine vom Aufnahmeboden hervorstehende Stirnfläche aufweist, die einer ebenen Kontaktfläche der Justierplatte gegenüberliegt, ist eine parallel zueinander gerichtete Führung des Substrats zu dem Stempel auf überraschend einfache Weise verwirklichbar, wobei die Kontaktflächen parallel zu dem Aufnahmeboden sowie parallel zu der Stirnfläche ausgerichtet oder ausrichtbar ist.

In einer besonders vorteilhaften Ausgestaltung der Erfindung ist der Arbeitsraum über eine Vakuumleitung durch eine Vakuumeinrichtung mit einem definierten Vakuum beaufschlagbar und in dem Arbeitsraum vorliegendes Fluid sowie aus der Fluidzuleitung in den Arbeitsraum eintretendes Fluid ist über die Vakuumleitung ableitbar. Damit kann im Arbeitsraum ein definierter Druck eingestellt werden.

Indem nach Einstellung eines definierten Vakuums im Arbeitsraum eine über die Vakuumleitung abgeleitete Ableitmenge A an Fluid Fv und Fluid Fz einer über die Fluidzuleitung zugeleiteten Zuleitmenge im Wesentlichen entspricht, befindet sich nach Einstellung des definierten Vakuums die abgeleitete und zugeleitete Menge an Fluid im Gleichgewicht und das Vakuum ist konstant.

Die in den Arbeitsraum aus dem Fluidlager entweichende Luft ist im Verhältnis zur Pumpenleistung der Vakuumanlage gering, so dass ein konstantes Vakuum aufrechterhalten werden kann.

Weitere Vorteile und zweckmäßige Ausführungen der Erfindung sind in den weiteren Ansprüchen, den Figuren, der Beschreibung und den Zeichnungen wiedergegeben.

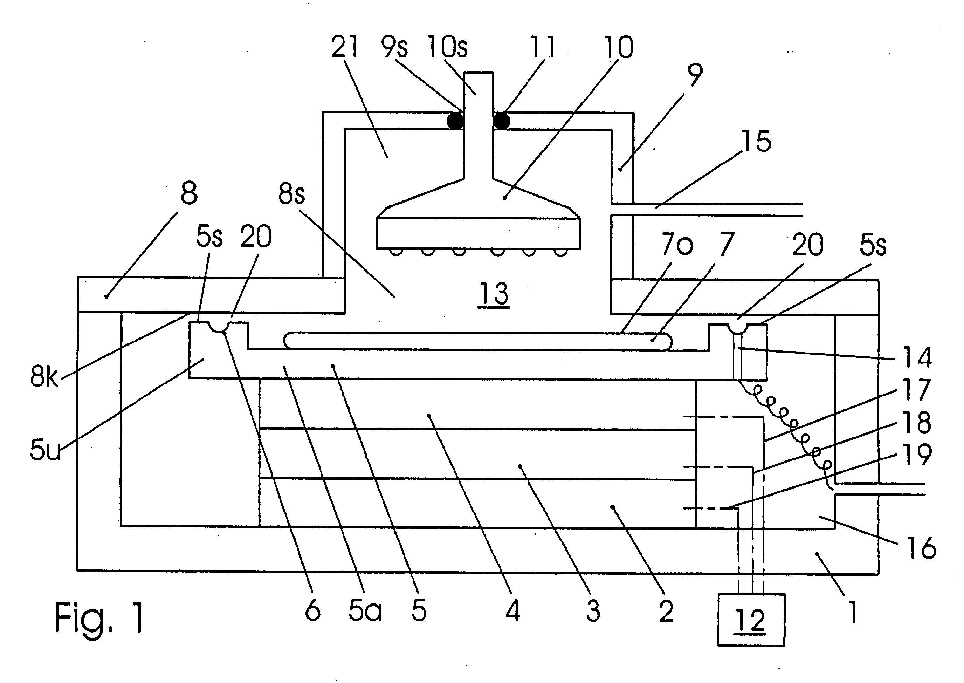

- Fig. 1 zeigt: eine geschnittene, schematische Seitenansicht der erfindungsgemäßen Vorrichtung.

In der einzigen Figur ist eine erfindungsgemäße Vorrichtung zum Bedrucken und/oder Prägen eines Halbleitersubstrats 7 mit einem Unterbau 1 sowie einer Justiereinrichtung 2, 3, 4 zur Justierung des Halbleitersubstrats 7 gegenüber einem Stempel 10 dargestellt.

Der Unterbau 1 kann offen oder geschlossen sein und erfüllt im Wesentlichen die Aufgabe, eine Justierplatte 8 stabil zu stützen oder zu fixieren. Innerhalb des vom Unterbau 1 begrenzten Raumes 16 ist die Justiereinrichtung 2, 3, 4 angeordnet und bei der in Fig. 1 gezeigten Ausführungsform ist diese an dem Unterbau 1 fixiert.

Die Justiereinrichtung 2, 3, 4 besteht aus einer Verstelleinheit in X-Richtung 2 und einer Verstelleinheit in Y-Richtung 3 sowie einer Rotiereinheit 4. Die Verstelleinheit in X-Richtung 2 ist für die Verstellung einer oberhalb der Justiereinrichtung 2, 3, 4 angeordneten Aufnahmeeinheit 5 in X-Richtung, d.h. in der Zeichnungsebene nach links und nach rechts, zuständig. Die Verstelleinheit in Y-Richtung 3 dient der Verstellung der Aufnahmeeinheit 5 in Y-Richtung, d.h. in Fig. 1 in die Zeichnungsebene hinein und aus der Zeichnungsebene heraus. Die Rotiereinheit 4 sorgt für eine Rotierung der Aufnahmeeinheit 5 in der durch X- und Y-Richtung aufgespannten Ebene E.

Die Steuerung der Justiereinrichtung 2, 3, 4 erfolgt durch mit den Verstelleinheiten 2, 3 und der Rotiereinheit 4 über Steuerleitungen 17, 18 und 19 verbundene Steuereinrichtung 12, wobei die Steuereinrichtung 12 innerhalb des Raumes 16 oder außerhalb des Unterbaus 1 angeordnet sein kann.

Die Aufnahmeeinheit 5 besteht aus einem Aufnahmeboden 5a sowie einer in Richtung der Justierplatte 8 hervorstehenden Umfangsschulter 5u, die sich über den gesamten Umfang des Aufnahmebodens 5a erstreckt. Die Aufnahmeeinheit 5 ist dadurch wannenförmig, wobei die Umfangsschulter 5u in einer Aufsicht kreisförmig oder in Form eines Vielecks, insbesondere eines Rechtecks ausgestaltet sein kann, vorzugsweise aber formkongruent zu dem Umfang des Halbleitersubstrats 7 ausgestaltet ist.

Die Umfangsschulter 5u weist eine in Richtung der Justierplatte 8 weisende Stirnfläche 5s auf, die plan parallel zu der in Richtung der Stirnfläche 5s weisenden Flachseite der Justierplatte 8 und insbesondere plan parallel zu der Ebene E ausgerichtet ist. Die in Richtung der Stirnfläche 5s weisende Flachseite der Justierplatte 8 weist eine Kontaktfläche 8k auf, entlang der die Aufnahmeeinheit 5 mit ihrer Stirnfläche 5s verschiebbar ist, wobei ein Kontakt der Stirnfläche 5s mit der Kontaktfläche 8k durch ein zwischen der Kontaktfläche 8k und der Stirnseite 5s gebildetes Fluidlager 20 vermieden wird, wodurch ein praktisch reibungsfreies Gleiten der Aufnahmeeinheit 5 parallel zu der Justierplatte 8 möglich ist. Die Aufnahmeeinheit 5 ist so ausgestaltet, dass die Oberfläche 7o des Halbleitersubstrats 7 parallel zu der Justierplatte 8 bzw. zu der Ebene E ausgerichtet ist.

Die Justierplatte 8 weist eine über der zu bearbeitenden Oberfläche 7o des Halbleitersubstrats 7 angeordnete Stempelöffnung 8s auf, durch welche der Stempel 10 auf das Halbleitersubstrat 7 in Z-Richtung abgesenkt werden kann.

Der Stempel 10 ist innerhalb eines den Stempel 10 haltenden Aufbaus 9 und eines durch den Aufbau 9 gebildeten Raums 21 auf und ab beweglich, wobei die Auf- und Ab-Bewegung durch eine nicht dargestellte, vorzugsweise außerhalb des Aufbaus 9 befindliche Betätigungseinrichtung bewirkt wird. Die Kraft von der Betätigungseinrichtung wird über einen Stempelschaft 10s übertragen, der durch eine Stempeldichtung 11 in einer Stempelschaftöffnung 9s des Aufbaus 9 geführt ist und diese durchsetzt.

Die Bewegung des Stempels 10 wird mit der Justiereinrichtung 2, 3, 4 koordiniert, vorzugsweise durch die Steuereinrichtung 12.

Ein Arbeitsraum 13, in welchem der Stempelprozess im Wesentlichen abläuft, wird durch die Aufnahmeeinrichtung 5, das Fluidlager 20, die Justierplatte 8 und den Aufbau 9 begrenzt. Die Justiereinrichtung 2, 3, 4 ist demnach außerhalb des Arbeitsraums 13 angeordnet.

Die im Arbeitsraum 13 erforderliche definierte Atmosphäre wie beispielsweise ein Vakuum oder Teilvakuum mit Reinluft wird durch Zuleitung eines entsprechenden, über die Fluidzuleitung 14 zugeleiteten Fluids Fz über das Fluidlager 20 in den Arbeitsraum 13 und durch Ableiten von in dem Arbeitsraum 13 befindlichen Fluid Fv sowie Fluid Fz über eine Vakuumleitung 15 und eine daran angeschlossene Vakuumanlage (nicht dargestellt) erzeugt, wobei nach Einstellung eines definierten Drucks in dem Arbeitsraum 13 die Ableitmenge A an Fluid Fv und Fluid Fz gleich der Zuleitmenge Z an Fluid Fz ist. Nach Einstellung des Gleichgewichts wird innerhalb kurzer Zeit im Arbeitsraum 13 nur noch das über die Fluidzuleitung 14 zugeführte Fluid Fz anwesend sein.

Das Fluidlager 20 ist durch möglichst gleichmäßig über die Stirnfläche 5s verteilte Öffnungen 6 so ausgestaltet, dass das Fluidlager 20 über die gesamte Stirnfläche 5s einen möglichst homogenen Druck bzw. Volumenstrom an zugeleitetem Fluid Fz zur Verfügung stellt. Als Öffnung 6 kann auch ein sich über den gesamten Umfang erstreckender Schlitz vorgesehen sein, der über mindestens eine Fluidzuleitung 14 gespeist wird, vorzugsweise über mehrere, gleichmäßig am Umfang der Aufnahmeeinheit 5 verteilte Fluidzuleitungen 14.

Dieser Aufbau bringt den besonderen Vorteil mit sich, dass etwaige Verunreinigungen bzw. Kontaminationen im Arbeitsraum 13 in dem ständigen Fluidstrom von der Fluidzuleitung 14 zu der Vakuumleitung 15 aus dem Arbeitsraum 13 herausbefördert werden.

### Bezugszeichenliste

- 1: Unterbau
- 2: Verstelleinheit in X-Richtung
- 3: Verstelleinheit in Y-Richtung
- 4: Rotiereinheit
- 5: Aufnahmeeinheit
- 5a: Aufnahmeboden
- 5u: Umfangsschulter
- 5s: Stirnfläche
- 6: Öffnung
- 7: Substrat
- 7o: Oberfläche
- 8: Justierplatte
- 8k: Kontaktfläche
- 8s: Stempelöffnung
- 9: Aufbau
- 9s: Stempelschaftöffnung
- 10: Stempel
- 10s: Stempelschaft
- 11: Stempeldichtung
- 12: Steuereinrichtung
- 13: Arbeitsraum
- 14: Fluidzuleitung
- 15: Vakuumleitung
- 16: Raum
- 17: Steuerleitung
- 18: Steuerleitung
- 19: Steuerleitung
- 20: Fluidlager
- 21: Raum
- Fv: Fluid
- Fz: Fluid
- A: Ableitmenge
- Z: Zuleitmenge
- E: Ebene

## Patentansprüche

1. Vorrichtung zum Bedrucken und/oder Prägen von Substraten (7), insbesondere Halbleitersubstraten oder Wafern, mit:
- einer Aufnahmeeinheit (5) zur Aufnahme des Substrats (7) in einem Arbeitsraum (13),
- einer Justiereinrichtung (2, 3, 4) zur Justierung des Substrats (7) gegenüber einem Präge- und/oder Druckstempel (10),
**dadurch gekennzeichnet,**
**dass** die Aufnahmeeinheit (5) den Arbeitsraum (13) von der Umgebung abtrennend ausgebildet ist, wobei der Arbeitsraum (13) durch ein Fluidlager (20) begrenzt ist.

2. Vorrichtung nach Anspruch 1, bei der Substrat (7) und Stempel (10) in dem abgetrennten Arbeitsraum (13) mit einer definierten Atmosphäre, insbesondere einem Vakuum oder Teilvakuum, vorzugsweise mit Reinluft, beaufschlagbar sind.

3. Vorrichtung nach Anspruch 1 oder 2, bei der der abgetrennte Arbeitsraum (13) durch einen den Stempel (10) aufnehmenden Aufbau (9), eine Justierplatte (8) und die Aufnahmeeinheit (5) gebildet ist.

4. Vorrichtung nach einem der vorhergehenden Ansprüche, bei der die Justiereinrichtung (2, 3, 4) zumindest teilweise, vorzugsweise vollständig, außerhalb des Arbeitsraums (13) angeordnet ist.

5. Vorrichtung nach Anspruch 3, bei der das durch mindestens eine Fluidzuleitung (14) mit Fluid (Fz), insbesondere Luft, vorzugsweise Reinluft, gespeiste Fluidlager (20) zwischen der, insbesondere wannenförmigen, Aufnahmeeinheit (5) und der Justierplatte (8) vorgesehen ist.

6. Vorrichtung nach einem der Ansprüche 2 bis 5, bei der die Aufnahmeeinheit (5), insbesondere einstückig, aus einem Aufnahmeboden (5a) und einer Umfangsschulter (5u) gebildet ist, wobei die Umfangsschulter (5u) eine vom Aufnahmeboden (5a) hervorstehende Stirnfläche (5s) aufweist, die einer ebenen Kontaktfläche (8k) der Justierplatte (8) gegenüberliegt.

7. Vorrichtung nach Anspruch 6, bei der die Kontaktfläche (8k) parallel zu dem Aufnahmeboden (5a) sowie parallel zu der Stirnfläche (5s) ausgerichtet oder ausrichtbar ist.

8. Vorrichtung nach einem der vorhergehenden Ansprüche, bei der der Arbeitsraum (13) über eine Vakuumleitung (15) durch eine Vakuumeinrichtung mit einem definierten Vakuum beaufschlagbar ist und in dem Arbeitsraum (13) vorliegendes Fluid (Fv) sowie aus der Fluidzuleitung (14) in den Arbeitsraum eintretendes Fluid (Fz) über die Vakuumleitung (15) ableitbar ist.

9. Vorrichtung nach einem der vorhergehenden Ansprüche, bei der nach Einstellung eines definierten Vakuums im Arbeitsraum (13) eine über die Vakuumleitung (15) abgeleitete Ableitmenge (A) an Fluid (Fv) und Fluid (Fz) einer über die Fluidzuleitung (14) zugeleiteten Zuleitmenge (Z) im Wesentlichen entspricht.

## Claims

1. An apparatus for imprinting and/or embossing substrates (7), in particular semiconductor substrates or wafers, having:
- a receiving unit (5) for receiving the substrate (7) in a working space (13),
- an adjusting device (2, 3, 4) for adjusting the substrate (7) in relation to an embossing and/or printing punch (10),
**characterised in that**
the receiving unit (5) is designed so as to separate the working space (13) from the environment, wherein the working space (13) is delimited by a fluid bearing (20).

2. Apparatus according to Claim 1, wherein the substrate (7) and the punch (10) in the separate working space (13) are capable of having a defined atmosphere, in particular a vacuum or partial vacuum, preferably with clean air, applied to them.

3. Apparatus according to Claim 1 or 2, wherein the separate working space (13) is constituted by a superstructure (9) receiving the punch (10), an adjusting plate (8) and the receiving unit (5).

4. Apparatus according to one of the preceding claims, wherein the adjusting device (2, 3, 4) is arranged at least partially, preferably completely, outside the working space (13).

5. Apparatus according to Claim 3, wherein the fluid bearing (20) which is fed with fluid (Fz), in particular air, preferably clean air, by at least one fluid feed line (14) is provided between the receiving unit (5), in particular the trough-shaped receiving unit (5), and the adjusting plate (8).

6. Apparatus according to one of Claims 2 to 5, wherein the receiving unit (5) is formed, in particular in one piece, from a receiving floor (5a) and a peripheral shoulder (5u), the peripheral shoulder (5u) exhibiting a front face (5s) protruding from the receiving floor (5a), which is situated opposite a flat contact face (8k) of the adjusting plate (8).

7. Apparatus according to Claim 6, wherein the contact face (8k) is oriented, or capable of being oriented, parallel to the receiving floor (5a) and also parallel to the front face (5s).

8. Apparatus according to one of the preceding claims, wherein the working space (13) is capable of having a defined vacuum applied to it via a vacuum line (15) by means of a vacuum device, and fluid (Fv) that is present in the working space (13) and also fluid (Fz) entering the working space from the fluid feed line (14) is capable of being drained away via the vacuum line (15).

9. Apparatus according to one of the preceding claims, wherein after a defined vacuum has been set in the working space (13) a drainage quantity (A) of fluid (Fv) and fluid (Fz) drained away via the vacuum line (15) corresponds substantially to a feed quantity (Z) fed via the fluid feed line (14).

## Revendications

1. Dispositif pour imprimer et/ou marquer des substrats (7), en particulier des substrats de semi-conducteurs ou des wafers comprenant :
- une unité de réception (5) pour recevoir le substrat (7) dans un espace de travail (13),
- un dispositif d'ajustage (2, 3, 4) pour ajuster le substrat (7) par rapport à un poinçon de marquage et/ou d'impression (10),
**caractérisé en ce que**
l'unité de réception (5) est construite en séparant l'espace de travail (13) de l'environnement, sachant que l'espace de travail (13) est délimité par un palier fluide (20).

2. Dispositif selon la revendication 1, dans lequel le substrat (7) et le poinçon (10) peuvent être alimentés dans l'espace de travail (13) séparé avec une atmosphère définie, en particulier un vide ou un vide partiel, de préférence avec de l'air pur.

3. Dispositif selon la revendication 1 ou 2, dans lequel l'espace de travail (13) séparé est formé par un montage (9) recevant le poinçon (10), une plaque d'ajustage (8) et l'unité de réception (5).

4. Dispositif selon l'une des revendications précédentes, dans lequel le dispositif d'ajustage (2, 3, 4) est disposé au moins partiellement, de préférence complètement, en dehors de l'espace de travail (13).

5. Dispositif selon la revendication 3, dans lequel le palier fluide (20) alimenté avec du fluide (Fz), en particulier de l'air, de préférence de l'air pur, par au moins un conduit d'arrivée de fluide (14), est prévu entre l'unité de réception (5) particulièrement en forme de cuve et la plaque d'ajustage (8).

6. Dispositif selon l'une des revendications 2 à 5, dans lequel l'unité de réception (5), en particulier de manière monobloc, est formée d'un fond de réception (5a) et d'un épaulement périphérique (5u), sachant que l'épaulement périphérique (5u) présente une face frontale (5s) faisant saillie du fond de réception (5a), laquelle est face à une surface de contact (8k) plane de la plaque d'ajustage (8).

7. Dispositif selon la revendication 6, dans lequel la surface de contact (8k) est alignée ou peut être alignée parallèlement au fond de réception (5a) ainsi que parallèlement à la face frontale (5s).

8. Dispositif selon l'une des revendications précédentes, dans lequel l'espace de travail (13) peut être alimenté avec un vide défini, via un conduit à vide (15) à travers un dispositif de vide, et du fluide (Fv) présent dans l'espace de travail (13) ainsi que du fluide (Fz) entrant du conduit d'arrivée de fluide (14) dans l'espace de travail, peut être dérivé par le conduit à vide (15).

9. Dispositif selon l'une des revendications précédentes, dans lequel, après réglage d'un vide défini dans l'espace de travail (13), une quantité de dérivation (A) de fluide (Fv) et de fluide (Fz) dérivée via le conduit à vide (15) correspond essentiellement à une quantité d'arrivage (z) amenée via le conduit d'arrivée de fluide (14).
